(19) Europäisches Patentamt / European Patent Office / Office européen des brevets

(11) **EP 4 331 840 B1**

(12) **EUROPEAN PATENT SPECIFICATION**

(45) Date of publication and mention of the grant of the patent:
**18.06.2025 Bulletin 2025/25**

(21) Application number: **22794225.7**

(22) Date of filing: **26.01.2022**

(51) International Patent Classification (IPC):
***B32B 27/36*** *(2006.01)*

(52) Cooperative Patent Classification (CPC):
**B42D 25/324; B42D 25/328; B42D 25/36; B42D 25/373**

(86) International application number:
**PCT/CN2022/074032**

(87) International publication number:
**WO 2022/227744 (03.11.2022 Gazette 2022/44)**

(54) **THIN FILM ELEMENT, TRANSPARENT ANTI-COUNTERFEITING ELEMENT, AND DATA CARRIER**

DÜNNSCHICHTELEMENT, TRANSPARENTES FÄLSCHUNGSSICHERES ELEMENT UND DATENTRÄGER

ÉLÉMENT EN FILM MINCE, ÉLÉMENT TRANSPARENT ANTI-CONTREFAÇON ET SUPPORT DE DONNÉES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.04.2021 CN 202110449714**

(43) Date of publication of application:
**06.03.2024 Bulletin 2024/10**

(73) Proprietors:
• **Zhongchao Special Security Technology Co., Ltd Beijing 100070 (CN)**
• **China Banknote Printing and Minting Corp. Beijing 100044 (CN)**

(72) Inventor: **SUN, Kai Beijing 100070 (CN)**

(74) Representative: **Glawe, Delfs, Moll Partnerschaft mbB Hopfenmarkt 33 20457 Hamburg (DE)**

(56) References cited:
EP-A1- 3 260 302          EP-A2- 2 219 168
WO-A1-2016/173696     CN-A- 104 169 098
CN-A- 105 228 835       CN-A- 108 349 290
US-A- 5 549 953           US-A1- 2010 307 705

**Description**

Technical Field

The present invention relates to the technical field of anti-counterfeiting, and in particular to a thin film element, a transparent anti-counterfeiting element, and a data carrier.

Background

To prevent counterfeiting by means of scanning, copying, etc., data carriers such as banknotes and financial instruments (for example, value or supporting documents) and other valuable items (for example, luxury brand items) are often equipped with security elements to verify the authenticity of the data carriers and prevent them from being reproduced without authority. However, with the development of reproduction methods, anti-counterfeiting elements that are more practical and more difficult to reproduce are still needed.

Document WO 2016/173696 A1 discloses a thin film element.

Summary

The objective of the present invention is to provide a thin film element. The thin film element is more practical and more difficult to reproduce.

In order to achieve the above objective, the present invention provides for a thin film element. The thin film element includes at least two low-refractive-index dielectric layers, at least two high-refractive-index dielectric layers, and at least one translucent reflective layer, the at least two high-refractive-index dielectric layers are located between the at least two low-refractive-index dielectric layers, the at least one translucent reflective layer is located between the two high-refractive-index dielectric layers, the thin film element presents at least two colors after reflection on one surface and reflection and transmission on the other surface.

The refractive index of the at least two high-refractive-index dielectric layers is at least 0.3 higher than a refractive index of the at least two low-refractive-index dielectric layers.

The refractive index of the at least two low-refractive-index dielectric layers ranges from 1.2 to 1.7.

The refractive index of the at least two high-refractive-index dielectric layers ranges from 1.7 to 2.5.

In some embodiments, a thickness of each of the at least two high-refractive-index dielectric layers ranges from 50nm to 300nm.

In some embodiments, one of structures of the thin film element is: the low-refractive-index dielectric layer, the high-refractive-index dielectric layer, the translucent reflective layer, the high-refractive-index dielectric layer, and the low-refractive-index dielectric layer in sequence.

In some embodiments, a thickness of the at least one translucent reflective layer is not greater than 30nm.

In some embodiments, the at least one translucent reflective layer is a metal layer.

In some embodiments, a material of the metal layer is one of Al, Ag, Cu, Cr, Ni, Fe and Au.

In some embodiments, the at least one translucent reflective layer is provided with a hollowed-out area.

In some embodiments, the at least one translucent reflective layer is made of semi-metal.

In some embodiments, the at least one translucent reflective layer is made of silicon or germanium.

In some embodiments, a color difference between the at least two colors in a CIELab color space is not less than 40.

In some embodiments, the thin film element presents a form of a pattern, text or a code.

In some embodiments, at least one surface of each layer structure of the thin film element is provided with a relief structure.

In some embodiments, the relief structure is one or a combination of a micro-optical relief structure, a diffraction relief structure, and a sub-wavelength relief structure.

Some other embodiments of the present invention further provide a transparent anti-counterfeiting element. The transparent anti-counterfeiting element includes a carrier and the thin film element above mentioned arranged on the carrier.

Still some other embodiments of the present invention further provide a data carrier. The data carrier is provided with the thin film element above mentioned. The thin film element is disposed in a transparent window area, or in a through hole, or above the through hole of the data carrier.

In some embodiments, the data carrier is a value document, a banknote, or an identity card.

With the above technical solutions, the thin film element according to the present invention includes the at least two low-refractive-index dielectric layers, the at least two high-refractive-index dielectric layers, and the at least one translucent reflective layer, the at least two high-refractive-index dielectric layers are located between the at least two low-refractive-index dielectric layers, the at least one translucent reflective layer is located between the two high-refractive-index dielectric layers, and the thin film element presents the at least two colors after reflection on one surface and reflection and transmission on the other surface. The thin film element is able to be used as an anti-counterfeiting element, so as to achieve being more practical and more difficult to reproduce.

Other features and advantages of the embodiments of the present invention will be described in detail in the following detailed description.

## Brief Description of the Drawings

The accompanying drawings, which are included to provide a further understanding of the present invention and constitute a part of the specification, serve to explain the embodiments of the present invention together with the detailed description below, but are not to be construed as limiting the embodiments of the present invention. In the figures:

Fig. 1 is a schematic structural diagram of a thin film element according to an embodiment of the present invention;

Figs. 2(a)-2(c) are reflection and transmission spectra of a thin film element;

Fig. 3 is a schematic structural diagram of a thin film element with a relief structure according to an embodiment of the present invention;

Fig. 4 is a schematic structural diagram of a thin film element with a hollowed-out area according to an embodiment of the present invention; and

Fig. 5 is a schematic structural diagram of a banknote.

Description of reference numerals

11. Low-refractive-index dielectric layer; 12. High-refractive-index dielectric layer; 13. Translucent reflective layer; 20. Relief structure; 30. Hollowed-out area; 101. Security thread; 102. Sticker; and 103. Perforated area.

## Detailed Description of the Embodiments

The specific implementations of the embodiments of the present invention are described in detail below with reference to the accompanying drawings. It is to be understood that the specific implementations described herein are merely illustrative and explanatory of the embodiments of the present invention, and are not restrictive of the embodiments of the present invention.

First, the design idea of an embodiment of the present invention is introduced:

Transparent windows have proven to be attractive anti-counterfeiting elements in polymer banknotes and, more recently, in paper banknotes as well because a plurality of security features are allowed. The special role of authenticity protection is played by an anti-counterfeiting element with view-based effects, as these effects are not able to be reproduced even with the most modern photocopiers. The anti-counterfeiting element here is provided with an optically variable element which conveys different image impressions to a viewer from different viewing angles, for example, displaying different color impressions or brightness impressions and/or different graphic patterns depending on the viewing angle. In this context, it is known to adopt anti-counterfeiting elements having multilayer thin film elements, the color impression of which varies with the viewing angle of the viewer. Moreover, when the thin film elements are tilted, the thin film elements change, for example, from green to blue, from blue to magenta or from magenta to green. This change in color, which occurs upon tilting of the thin film elements, is referred to as a color-shift effect hereinafter.

Another special role in authenticity protection is played by a transparent anti-counterfeiting element that shows an appearance contrast between an overhead view and a transmitted light view.

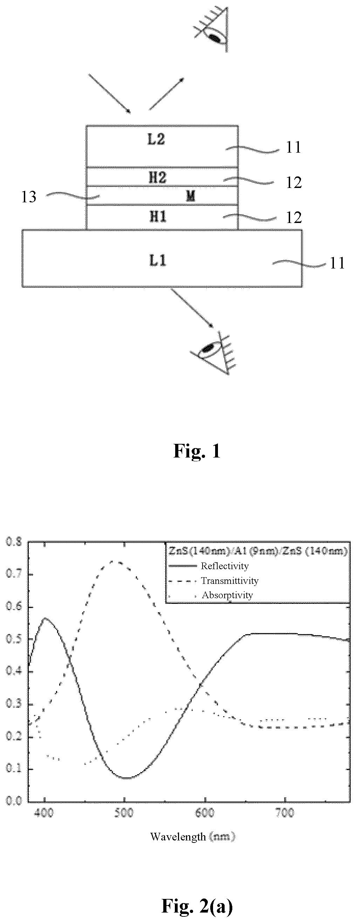

Fig. 1 is a schematic structural diagram of a thin film element according to an embodiment of the present invention. Referring to Fig. 1, the thin film element includes at least two low-refractive-index dielectric layers 11 (for example, a layer L1 and a layer L2), at least two high-refractive-index dielectric layers 12 (for example, a layer H1 and a layer H2), and at least one translucent reflective layer 13 (for example, a layer M).

The at least two high-refractive-index dielectric layers 12 are located between the at least two low-refractive-index dielectric layers 11. The at least one translucent reflective layer 13 is located between the two high-refractive-index dielectric layers 12. The thin film element presents at least two colors after reflection on one surface and reflection and transmission on the other surface.

In some embodiments, a refractive index of the at least two high-refractive-index dielectric layers 12 is at least 0.3 higher than a refractive index of the at least two low-refractive-index dielectric layers 11.

In some embodiments, the refractive index of the at least two low-refractive-index dielectric layers 11 ranges from 1.2 to 1.7. For example, the refractive indexes of the layer L1 and the layer L2 are about 1.5.

In some embodiments, the refractive index of the at least two high-refractive-index dielectric layers 12 ranges from 1.7 to 2.5. For example, the refractive indexes of the layer H1 and the layer H2 are about 2.2.

In some embodiments, one of structures of the thin film element is: the low-refractive-index dielectric layer 11, the high-refractive-index dielectric layer 12, the translucent reflective layer 13, the high-refractive-index dielectric layer 12, and the low-refractive-index dielectric layer 11 in sequence. For example, the thin film element is of a symmetrical five-layer structure L1/H1/M/H2/L2.

In some embodiments, the at least one translucent reflective layer 13 is a metal layer. Specifically, a material of the metal layer is one of Al, Ag, Cu, Cr, Ni, Fe and Au.

The translucent reflective layer 13 is made of metal, and depending on a thickness, the translucent reflective layer 13 is a homogeneous continuous film layer, or is formed by clusters, that is, by films with discontinuities. An optical effect of Fabry-Perot resonance also occurs in this case.

In some embodiments, a thickness of the at least one translucent reflective layer 13 is not greater than 30nm.

Specifically, referring to Fig. 1, the thin film element is of the symmetrical five-layer structure L1/H1/M/H2/L2, wherein L1 and L2 are the low-refractive-index dielectric layers 11, H1 and H2 are the high-refractive-index dielectric layers 12, and the absorptivity of visible light by dielectric materials is very low. The refractive indexes of L1 and L2 are about 1.5, wherein L1 is a plastic substrate, L2 is a polymer protective layer, and thicknesses of the two are greater than 1μm, preferably, greater than 3μm. The refractive indexes of H1 and H2 are greater than 1.7, and H1 has the same thickness as H2. M is a metal Ag or Al layer with a thickness of 15nm.

For another example, referring to Fig. 1, the thin film element is of an asymmetrical five-layer structure, wherein L1 and L2 are the low-refractive-index dielectric layers 11, H1 and H2 are the high-refractive-index dielectric layers 12, and the absorptivity of visible light by dielectric materials is very low. The refractive indexes of L1 and L2 are about 1.5, where L1 is a plastic substrate, L2 is a polymer protective layer, and thicknesses of the two are greater than 1μm, preferably, greater than 3μm. H1 and H2 have different materials and/or thicknesses, and the refractive indexes of the two are greater than 1.7. M is a metal Ag or Al layer with a thickness of 15nm. The above thin film structure is a PET/ZnS/Al/ZnS/ polymer coating system.

In some embodiments, a thickness of each of the at least two high-refractive-index dielectric layers 12 ranges from 50nm to 300nm.

In an embodiment, the high-refractive-index dielectric layers 12 are made of ZnS or $TiO_2$. The layer thickness of the high-refractive-index dielectric layers 12 is generally between 50nm and 300nm. As the color impression of the thin film element is essentially determined by the layer thickness of the high-refractive-index dielectric layers 12, as described in detail below, the thickness is selected based on a desired color impression intensity.

Specifically, referring to Fig. 1, L1 is a low-refractive-index transparent substrate, H1 is a high-refractive-index dielectric, M is a metal layer, H2 is a high-refractive-index dielectric, and L2 is a low-refractive-index coating. The refractive indexes of the layer L1 and the layer L2 are 1.2-1.7, preferably 1.4-1.5. The refractive indexes of the layer H1 and the layer H2 are selected as 1.7-2.5, and the thicknesses are 50-300 nm, preferably, 100-200nm. The layer M is a metal or semi-metal layer, with the thickness being not greater than 30nm, and is able to simultaneously partially reflect and partially transmit incident light. The incident light 21 is incident from an upper surface of the thin film element and produces reflected light and transmitted light. The observer will see the reflected light on the same side of the incident light, and the observer will see the transmitted light on the opposite side of the incident light. In the thin film element, the reflected light is different from the transmitted light in color.

In some embodiments, a color difference between the at least two colors in a CIELab color space is not less than 40.

Accordingly, the thin film element presents bright metal luster and is essentially achromatic when viewed in the reflected light, and is colorful when viewed in the transmitted light. The chroma $C_{ab}^*$ of the thin film element in the transmitted light is greater than 15, preferably, greater than 20, and particularly preferably, greater than 25. The chroma $C_{ab}^*$ is specified in the CIELab color space.

For example,

Table 1-Reflection color and transmission color of an exemplary thin film element 1

| PET/ZnS/Ag/ZnS/PET laminated thickness (nm) | Reflection color | Transmission color |
|---|---|---|
| 15000/110/20/110/15000 | Golden | Blue |
| 15000/135/20/135/15000 | Orange | Green |

(continued)

| PET/ZnS/Ag/ZnS/PET laminated thickness (nm) | Reflection color | Transmission color |
|---|---|---|
| 15000/190/20/190/15000 | Green | Magenta |
| 15000/220/20/220/15000 | Golden | Blue |

Table 2-Reflection color and transmission color of an exemplary thin film element 2

| PET/ZnS/Al/ZnS/PET laminated thickness (nm) | Reflection color | Transmission color |
|---|---|---|
| 15000/120/12/120/15000 | Golden | Blue |
| 15000/140/8/140/15000 | Magenta | Cyan |
| 15000/180/8/180/15000 | Cyan | Tangerine |
| 15000/200/8/200/15000 | Green | Magenta |
| 15000/220/8/220/15000 | Golden | Blue |

In the structure of the thin film element in Table 1, L1 is PET, H1 is ZnS, M is Ag, H2 is ZnS, and L2 is PET. In the structure of the thin film element in Table 2, L1 is PET, H1 is ZnS, M is Al, H2 is ZnS, and L2 is PET:

(1) For the structure of the thin film element with a laminated thickness (nm) of (15000/110/20/110/15000) in Table 1, when viewed vertically in the transmitted light, the thin film element is blue and has a chroma $C_{ab}^*$ greater than 20, preferably, greater than 30, meanwhile, the thin film element is golden when viewed in the reflected light, and a color difference between the two colors is greater than 40.

(2) For the structure of the thin film element with a laminated thickness (nm) of (15000/140/8/140/15000) in Table 2, when viewed vertically in the transmitted light, the thin film element is cyan and has a chroma $C_{ab}^*$ greater than 30, preferably, greater than 40, meanwhile, the thin film element is magenta when viewed in the reflected light, and a color difference between the two colors is greater than 45.

(3) For the structure of the thin film element with a laminated thickness (nm) of (15000/135/20/135/15000) in Table 1, when viewed vertically in the transmitted light, the thin film element is green and has a chroma $C_{ab}^*$ greater than 25, preferably, greater than 35, meanwhile, the thin film element is orange when viewed in the reflected light, and a color difference between the two colors is greater than 45.

(4) For the structure of the thin film element with a laminated thickness (nm) of (15000/200/8/200/15000) in Table 2, when viewed vertically in the transmitted light, the thin film element is magenta and has a chroma $C_{ab}^*$ greater than 30, preferably, greater than 35, meanwhile, the thin film element is green when viewed in the reflected light, and a color difference between the two colors is greater than 45.

For another example,

(1) Fig. 2(a) is reflection and transmission spectra of a first type of thin film element. The structure (L1/H1/M/H2/L2) of the thin film element is PET(15μm)/ZnS(140nm)/Al(9nm)/ZnS(140nm)/PET(15μm). Referring to Fig. 2(a), the reflection spectrum has a clear low reflection near 500nm, and thus the reflection has a magenta color. The transmission spectrum has a high transmission near 500nm, and thus the transmitted light has a green color.

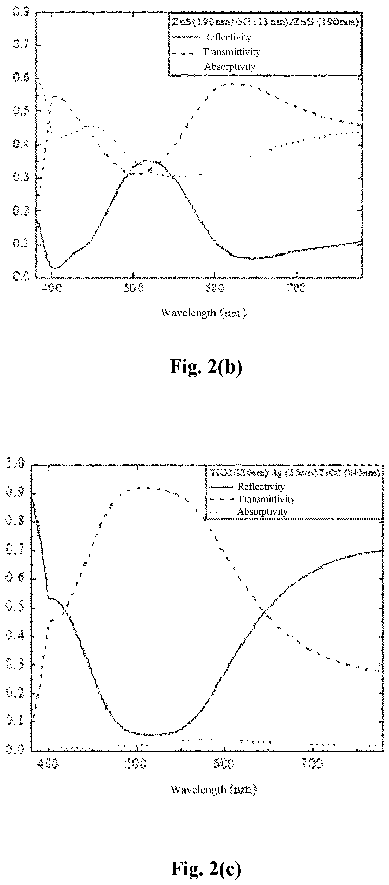

(2) Fig. 2(b) is reflection and transmission spectra of a second type of thin film element. The structure (L1/H1/M/H2/L2) of the thin film element is PET(15μm)/ZnS(190nm)/Ni(13nm)/ZnS(190nm)/PET(15μm). Referring to Fig. 2(b), the reflection spectrum has a clear high reflection near 510nm, and thus the reflection has a green color. The transmission spectrum has a high transmission near 500nm, and thus the transmitted light has a magenta color.

(3) Fig. 2(c) is reflection and transmission spectra of a third type of thin film element. The structure (L1/H1/M/H2/L2) of the thin film element is PET(15$\mu$m)/TiO2(130nm)/Ag(15nm)/TiO2(145nm)/PET(15$\mu$m). Referring to Fig. 2(c), the reflection spectrum has a clear low reflection near 520nm, and thus the reflection has a magenta color. The transmission spectrum has a high transmission near 510nm, and thus the transmitted light has a green color. The metal Ag has low absorptivity for light, which thus facilitates the production of colors of higher quality.

Further, the thin film element is colored in the transmitted light and has a color-shift effect. When the thin film element is tilted, the color impression of the thin film element changes in the transmitted light, for example, changing from magenta in a vertical view to green in a tilted view. Accordingly, the thin film element is colored in the transmitted light, and when the thin film element is tilted, the thin film element does not change color substantially, but has a transparent color with a change in chroma $C_{ab}^*$ The color impression in the transmitted light is, for example, blue, and the chroma of the blue transparent color changes from a high value in the vertical view to a low value in the tilted view. In this case, when the thin film element is tilted, only the saturation of the recognizable blue transparent color changes.

In some embodiments, at least one surface of each layer structure of the thin film element is provided with a relief structure.

In some embodiments, the relief structure is one or a combination of a micro-optical relief structure, a diffraction relief structure, and a sub-wavelength relief structure.

The at least one surface of the layers of the thin film element according to the embodiment of the present invention is provided with the relief structure, such as a diffraction relief structure (for example, a hologram), a micro-optical relief structure (for example, three-dimensional reproduction of a microlens structure and a serrated structure), or a sub-wavelength grating, moth-eye structure. The thin film element according to the embodiment of the present invention is also able to be combined with an optically variable coating, in particular with a coating that has a combination of a color variable area and a color constant area.

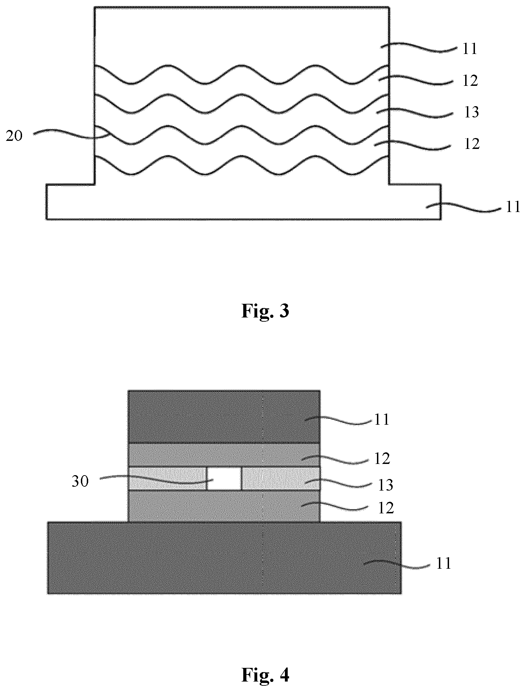

Specifically, Fig. 3 is a schematic structural diagram of the thin film element with the relief structure according to an embodiment of the present invention. Referring to Fig. 3, the structure of the thin film element is, from top to bottom: the low-refractive-index dielectric layer 11 is a low-refractive-index transparent substrate, the high-refractive-index dielectric layer 12 is a high-refractive-index dielectric, the translucent reflective layer 13 is a metal layer, the high-refractive-index dielectric layer 12 is the high-refractive-index dielectric, and the low-refractive-index dielectric layer 11 is a low-refractive-index coating. The refractive index of the low-refractive-index dielectric layers 11 is 1.2-1.7, preferably 1.4-1. The refractive index of the high-refractive-index dielectric layers 12 is selected as 1.7-2.5, and the thickness is 50-300nm, preferably, 100-200nm. The translucent reflective layer 13 is a metal or semi-metal layer, with the thickness being not greater than 30nm, and is able to simultaneously partially reflect and partially transmit incident light. The at least one surface of the low-refractive-index dielectric layers 11, the high-refractive-index dielectric layers 12, and the translucent reflective layer 13 is modulated by a surface relief structure 20. The surface relief structure 20 is a diffraction relief structure (for example, a hologram), a micro-optical relief structure (for example, three-dimensional reproduction of a microlens structure and a serrated structure), or a sub-wavelength grating, moth-eye structure. A transverse size of the diffraction relief structure is 0.7-10$\mu$m, and a depth is 60-600nm. A transverse size of the microlens structure may be 10-40$\mu$m and a depth may be 2-20$\mu$m. A transverse size of the serrated structure is 5-20$\mu$m, and a depth is 0.8-3$\mu$m. A transverse size of the sub-wavelength grating, moth-eye structure is 0.1-0.6$\mu$m, and a depth is 30-300nm. The effect of the surface relief structure 20 on light includes one or more of wavelength-dependent selective absorption, wavelength-independent undifferentiated absorption, wavelength-dependent modulation of a propagation direction, and wavelength-independent undifferentiated modulation of the propagation direction.

In some embodiments, the at least one translucent reflective layer 13 is provided with a hollowed-out area.

In some embodiments, the at least one translucent reflective layer 13 is made of semi-metal, preferably, silicon or germanium.

The translucent reflective layer 13 of the thin film element according to the embodiment of the present invention, for example, a metal reflective layer, is provided with the hollowed-out area. A hollowing method is chemical corrosion on a metal material by acid or alkali. By providing a special structure in the hollowed-out area, the rate of chemical corrosion at this position and the rate of separation of the metal layer are accelerated by increasing a reaction contact area or creating a vulnerable point, etc. A physical peeling method is also adopted, that is, a peeling layer is disposed in the hollowed-out area. The peeling layer is rapidly dissolved under specific conditions, and a coating structure attached thereto also falls off.

Specifically, Fig. 4 is a schematic structural diagram of the thin film element with the hollowed-out area according to an embodiment of the present invention. Referring to Fig. 4, the structure of the thin film element is, from top to bottom: the low-refractive-index dielectric layer 11 is a low-refractive-index transparent substrate, the high-refractive-index dielectric layer 12 is a high-refractive-index dielectric, the translucent reflective layer 13 is a metal layer, the high-refractive-index dielectric layer 12 is the high-refractive-index dielectric, and the low-refractive-index dielectric layer 11 is a low-refractive-index coating. The refractive index of the low-refractive-index dielectric layers 11 is 1.2-1.7, preferably, 1.4-1.5. The refractive index of the high-refractive-index dielectric layers 12 is selected as 1.7-2.5, and the thickness is 50-300nm, preferably, 100-200nm. The translucent reflective layer 13 is a metal or semi-metal layer, with the thickness being not greater than 30nm, and is able to simultaneously partially reflect and partially transmit incident light. The hollowed-out area 30 is provided in the translucent reflective layer 13, so that the incident light substantially completely penetrates through the hollowed-out area 30, without producing an obvious color. A hollowing method is chemical corrosion on a metal material by acid or alkali. By providing a special structure in the hollowed-out area, the rate of chemical corrosion at this position and the rate of separation of the metal layer are accelerated by increasing a reaction contact area or creating a vulnerable point, etc. A physical peeling method is also adopted, that is, a peeling layer is disposed in the hollowed-out area 30. The peeling layer is rapidly dissolved under specific conditions, and a coating structure attached thereto also falls off.

In some embodiments, the thin film element presents a form of a pattern, text or a code.

In addition, gaps in the form of the pattern, text or the code are provided in the entire surface of the thin film element.

Further, the thin film element according to the embodiment of the present invention is fabricated by thermal evaporation, electron beam evaporation (EBV), or sputtering, and also has radiation-curable lacquer (for example, UV lacquer), polymers, and a plastic substrate.

Some embodiments of the present invention further provide a transparent anti-counterfeiting element. The transparent anti-counterfeiting element includes a carrier and the above-mentioned thin film element arranged on the carrier.

Meanwhile, some embodiments of the present invention further provide a data carrier. The data carrier is provided with the above-mentioned thin film element.

The thin film element is arranged in a transparent window area, or in a through hole, or above the through hole of the data carrier.

In some embodiments, the data carrier is a value document, a banknote, or an identity card.

The data carrier is particularly a value document, such as a banknote (particularly a paper banknote), a polymer banknote, or an identity card (such as a credit card, a bank card, a cash card, an authorization card, a personal identity card or a personal particulars page of a passport).

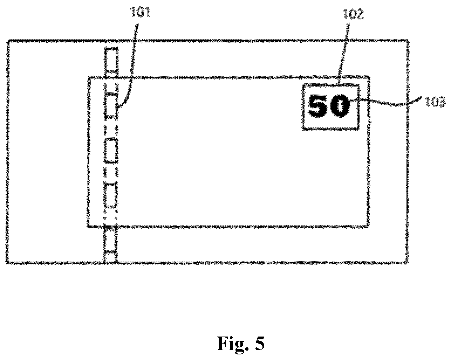

Specifically, Fig. 5 is a schematic structural diagram of a banknote. Referring to Fig. 5, the banknote has the thin film element according to the embodiment of the present invention, and the thin film element is embedded within the banknote in the form of a window security thread 101. In addition, the thin film element is also used in the form of a sticker 102, and a perforated area 103 is provided in a substrate of the banknote for light transmission observation.

In addition, the embodiment of the present invention is not limited to the security thread or the banknote, but is used in various thin film elements, for example in labels on goods and packaging, or in security documents, identity cards, passports, credit cards, health care cards, etc. In the banknote and a similar document, in addition to the security thread and the sticker, a wide security bar or a transfer element may also be used, for example.

It is also to be noted that the terms "comprise", "include", or any other variation thereof, are intended to cover a non-exclusive inclusion, such that a process, method, article, or apparatus that includes a list of elements not only include those elements, but also includes other elements not expressly listed or elements inherent to such process, method, article, or apparatus. An element proceeded by the phrase "comprises a" does not, without more constraints, preclude the existence of additional identical elements in the process, method, article, or apparatus that includes the element.

The foregoing is merely embodiments of the present application, and is not intended to limit the present application. It will be apparent to those skilled in the art that various modifications and variations may be made to the present application, as long as they fall within the scope of the claims of the present application.

**Claims**

1.    A thin film element, comprising at least two low-refractive-index dielectric layers (11), at least two high-refractive-index dielectric layers (12), and at least one translucent reflective layer (13),

the at least two high-refractive-index dielectric layers (12) are located between the at least two low-refractive-index dielectric layers (11), the at least one translucent reflective layer (13) is located between the two high-refractive-index dielectric layers (12), the thin film element presents at least two colors when an incident light is incident from one surface of the thin film element, one color is produced by reflection and observable from the one surface, and the other color is produced by transmission and observable from the other surface of the thin film element;
a refractive index of the at least two high-refractive-index dielectric layers (12) is at least 0.3 higher than a refractive index of the at least two low-refractive-index dielectric layers (11);
a refractive index of the at least two low-refractive-index dielectric layers (11) ranges from 1.2 to 1.7;

a refractive index of the at least two high-refractive-index dielectric layers (12) ranges from 1.7 to 2.5.

2. The thin film element as claimed in claim 1, wherein a thickness of each of the at least two high-refractive-index dielectric layers (12) ranges from 50nm to 300nm.

3. The thin film element as claimed in claim 1, wherein one of structures of the thin film element is: the low-refractive-index dielectric layer (11), the high-refractive-index dielectric layer (12), the translucent reflective layer (13), the high-refractive-index dielectric layer (12), and the low-refractive-index dielectric layer (11) in sequence.

4. The thin film element as claimed in claim 1, wherein a thickness of the at least one translucent reflective layer (13) is not greater than 30nm.

5. The thin film element as claimed in claim 1, wherein the at least one translucent reflective layer (13) is a metal layer.

6. The thin film element as claimed in claim 1, wherein the at least one translucent reflective layer (13) is provided with a hollowed-out area (30).

7. The thin film element as claimed in claim 1, wherein the at least one translucent reflective layer (13) is made of semi-metal.

8. The thin film element as claimed in claim 1, wherein a color difference between the at least two colors in a CIELab color space is not less than 40.

9. The thin film element as claimed in claim 1, wherein the thin film element presents a form of a pattern, text or a code.

10. The thin film element as claimed in claim 1, wherein at least one surface of each layer structure of the thin film element is provided with a relief structure (20).

11. A transparent anti-counterfeiting element, comprising a carrier and the thin film element as claimed in any one of claims 1 to 10 arranged on the carrier.

12. A data carrier, comprising the thin film element as claimed in any one of claims 1 to 10, and the thin film element is arranged in a transparent window area, or in a through hole, or above the through hole of the data carrier.

**Patentansprüche**

1. Dünnschichtelement, das mindestens zwei dielektrische Schichten (11) mit niedrigem Brechungsindex, mindestens zwei dielektrische Schichten (12) mit hohem Brechungsindex und mindestens eine lichtdurchlässige reflektierende Schicht (13) aufweist,

wobei die mindestens zwei dielektrischen Schichten (12) mit hohem Brechungsindex zwischen den mindestens zwei dielektrischen Schichten (11) mit niedrigem Brechungsindex angeordnet sind, die mindestens eine lichtdurchlässige reflektierende Schicht (13) zwischen den zwei dielektrischen Schichten (12) mit hohem Brechungsindex angeordnet ist, und das Dünnschichtelement mindestens zwei Farben zeigt, wenn ein einfallendes Licht von einer Oberfläche des Dünnschichtelements einfällt, wobei eine Fabre produziert wird durch Reflexion und beobachtbar von der einen Oberfläche und die andere Fabre produziert wird durch Transmission und beobachtbar von der anderen Oberfläche des Dünnschichtelements,
wobei ein Brechungsindex der mindestens zwei dielektrischen Schichten (12) mit hohem Brechungsindex um mindestens 0,3 höher ist als ein Brechungsindex der mindestens zwei dielektrischen Schichten (11) mit niedrigem Brechungsindex, wobei ein Brechungsindex der mindestens zwei dielektrischen Schichten (11) mit niedrigem Brechungsindex im Bereich von 1,2 bis 1,7 liegt,
wobei der Brechungsindex der mindestens zwei dielektrischen Schichten (12) mit hohem Brechungsindex im Bereich von 1,7 bis 2,5 liegt.

2. Dünnschichtelement nach Anspruch 1, wobei die Dicke jeder der mindestens zwei dielektrischen Schichten (12) mit hohem Brechungsindex im Bereich von 50 nm bis 300 nm liegt.

**3.** Dünnschichtelement nach Anspruch 1, wobei eine der Strukturen des Dünnschichtelements ist: die dielektrische Schicht (11) mit niedrigem Brechungsindex, die dielektrische Schicht (12) mit hohem Brechungsindex, die lichtdurchlässige reflektierende Schicht (13), die dielektrische Schicht (12) mit hohem Brechungsindex und die dielektrische Schicht (11) mit niedrigem Brechungsindex in Folge.

**4.** Dünnschichtelement nach Anspruch 1, wobei eine Dicke der mindestens einen lichtdurchlässigen reflektierenden Schicht (13) nicht größer als 30 nm ist.

**5.** Dünnschichtelement nach Anspruch 1, wobei die mindestens eine lichtdurchlässige reflektierende Schicht (13) eine Metallschicht ist.

**6.** Dünnschichtelement nach Anspruch 1, wobei die mindestens eine lichtdurchlässige reflektierende Schicht (13) mit einem ausgehöhlten Bereich (30) versehen ist.

**7.** Dünnschichtelement nach Anspruch 1, wobei die mindestens eine lichtdurchlässige reflektierende Schicht (13) aus Halbmetall ist.

**8.** Dünnschichtelement nach Anspruch 1, wobei ein Farbunterschied zwischen den mindestens zwei Farben in einem CIELab-Farbraum nicht weniger als 40 beträgt.

**9.** Dünnschichtelement nach Anspruch 1, wobei das Dünnschichtelement die Form eines Musters, eines Textes oder eines Codes aufweist.

**10.** Dünnschichtelement nach Anspruch 1, wobei mindestens eine Oberfläche jeder Schichtstruktur des Dünnschichtelements mit einer Reliefstruktur (20) versehen ist.

**11.** Transparentes, fälschungssicheres Element, aufweisend einen Träger und das Dünnschichtelement nach einem der Ansprüche 1 bis 10, das auf dem Träger angeordnet ist.

**12.** Datenträger, aufweisend das Dünnschichtelement nach einem der Ansprüche 1 bis 10, wobei das Dünnschichtelement in einem transparenten Fensterbereich oder in einem Durchgangsloch oder über dem Durchgangsloch des Datenträgers angeordnet ist.

## Revendications

**1.** Élément en couches minces, comprenant au moins deux couches diélectriques à faible indice de réfraction (11), au moins deux couches diélectriques à fort indice de réfraction (12), et au moins une couche réfléchissante translucide (13),

les au moins deux couches diélectriques à fort indice de réfraction (12) sont situées entre les au moins deux couches diélectriques à faible indice de réfraction (11), l'au moins une couche réfléchissante translucide (13) est située entre les deux couches diélectriques à fort indice de réfraction (12), l'élément en couches minces présente au moins deux couleurs quand une lumière incidente est incidente depuis une surface donnée de l'élément en couches minces, une couleur est produite par réflexion et observable depuis la surface donnée, et l'autre couleur est produite par transmission et observable depuis l'autre surface de l'élément en couches minces ; un indice de réfraction des au moins deux couches diélectriques à fort indice de réfraction (12) est supérieur d'au moins 0,3 à un indice de réfraction des au moins deux couches diélectriques à faible indice de réfraction (11) ;
un indice de réfraction des au moins deux couches diélectriques à faible indice de réfraction (11) va de 1,2 à 1,7 ;
un indice de réfraction des au moins deux couches diélectriques à fort indice de réfraction (12) va de 1,7 à 2,5.

**2.** Élément en couches minces selon la revendication 1, dans lequel une épaisseur de chacune des au moins deux couches diélectriques à fort indice de réfraction (12) va de 50 nm à 300 nm.

**3.** Élément en couches minces selon la revendication 1, une des structures de l'élément en couches minces étant :

la couche diélectrique à faible indice de réfraction (11), la couche diélectrique à fort indice de réfraction (12), la couche réfléchissante translucide (13), la couche diélectrique à fort indice de réfraction (12) et

la couche diélectrique à faible indice de réfraction (11) dans cet ordre.

4. Élément en couches minces selon la revendication 1, dans lequel une épaisseur de l'au moins une couche réfléchissante translucide (13) ne dépasse pas 30 nm.

5. Élément en couches minces selon la revendication 1, dans lequel l'au moins une couche réfléchissante translucide (13) est une couche métallique.

6. Élément en couches minces selon la revendication 1, dans lequel l'au moins une couche réfléchissante translucide (13) est pourvue d'une zone évidée (30).

7. Élément en couches minces selon la revendication 1, dans lequel l'au moins une couche réfléchissante translucide (13) est constituée de semi-métal.

8. Élément en couches minces selon la revendication 1, dans lequel une différence de couleur entre les au moins deux couleurs dans un espace colorimétrique CIELab n'est pas inférieure à 40.

9. Élément en couches minces selon la revendication 1, dans lequel l'élément en couches minces présente une forme de motif, de texte ou de code.

10. Élément en couches minces selon la revendication 1, dans lequel au moins une surface de chaque structure de couche de l'élément en couches minces est pourvue d'une structure en relief (20).

11. Élément anti-contrefaçon transparent, comprenant un support et l'élément en couches minces selon l'une quelconque des revendications 1 à 10 disposé sur le support.

12. Support de données, comprenant l'élément en couches minces selon l'une quelconque des revendications 1 à 10, l'élément en couches minces étant disposé dans une zone de fenêtre transparente, ou dans un trou débouchant, ou au-dessus du trou débouchant du support de données.

**Fig. 1**

**Fig. 2(a)**

**Fig. 2(b)**

**Fig. 2(c)**

11

12

13

12

20

11

**Fig. 3**

11

12

13

12

30

11

**Fig. 4**

**Fig. 5**

**EP 4 331 840 B1**

**Patent documents cited in the description**

- WO 2016173696 A1